# EUROPÄISCHE PATENTSCHRIFT

(11) **EP 3 358 628 B1**
(45) Veröffentlichungstag und Bekanntmachung des Hinweises auf die Patenterteilung: **23.10.2019**
(21) Anmeldenummer: 17210701.3
(22) Anmeldetag: 27.12.2017
(51) Int. Cl.: H01L 31/0352, H01L 31/05

(54) **VERFAHREN ZUR HERSTELLUNG EINES PHOTOVOLTAIKBAUTEILS UND PHOTOVOLTAIKBAUTEIL**
PHOTOVOLTAIC COMPONENT AND METHOD FOR PRODUCING A PHOTOVOLTAIC COMPONENT
PROCÉDÉ DE FABRICATION D'UN COMPOSANT PHOTOVOLTAÏQUE ET COMPOSANT PHOTOVOLTAÏQUE

(30) Priorität: 07.02.2017 AT 500962017
(43) Veröffentlichungstag der Anmeldung: 08.08.2018
(73) Patentinhaber: Joanneum Research Forschungsgesellschaft mbH, 8010 Graz (AT)
(72) Erfinder: Peharz, Gerhard, 8200 Gleisdorf (AT); Satzinger, Valentin, 8010 Graz (AT); Sax, Stefan, 8054 Graz (AT)
(74) Vertreter: Patentanwaltskanzlei Matschnig & Forsthuber OG

(56) Entgegenhaltungen:
- EP-A1- 1 521 309
- JP-A- H04 207 085
- JP-A- H06 163 953
- US-A- 4 407 320
- US-A1- 2011 114 157

## Beschreibung

Die Erfindung bezieht sich auf ein Verfahren zur Herstellung eines Photovoltaikbauteils, welches aus einzelnen, in Serie geschalteten Solarzellen besteht, wobei in jeder Solarzelle Halbleiterkörner in einer Isolierschicht angeordnet sind, aus welcher die Halbleiterkörner an einer Frontseite vorragen, an einer gegenüberliegenden Rückseite auf einer leitenden Unterschicht sitzen und an der Frontseite mit einer leitenden Frontkontaktschicht in elektrischer Verbindung stehen, wobei zwischen benachbarten Solarzellen ein Trenngraben vorgesehen ist, in dessen Bereich die Solarzellen elektrisch dadurch miteinander in Serie geschaltet sind, dass je die Frontkontaktschicht einer Solarzelle mit der leitenden Unterschicht einer benachbarten Solarzelle verbunden ist.

Ebenso bezieht sich die Erfindung auf ein Photovoltaikbauteil, welches aus einzelnen, in Serie geschalteten Solarzellen besteht, wobei in jeder Solarzelle Halbleiterkörner in einer Isolierschicht angeordnet sind, aus welcher die Halbleiterkörner an einer Frontseite vorragen, an einer gegenüberliegenden Rückseite auf einer leitenden Unterschicht sitzen und an der Frontseite mit einer leitenden Frontkontaktschicht in elektrischer Verbindung stehen, wobei zwischen benachbarten Solarzellen ein Trenngraben vorgesehen ist, in dessen Bereich die Solarzellen elektrisch dadurch miteinander in Serie geschaltet sind, dass je die Frontkontaktschicht einer Solarzelle mit der leitenden Unterschicht einer benachbarten Solarzelle verbunden ist.

Ein Verfahren dieser Art und ebenso ein gegenständliches Photovoltaikbauteil gehen beispielsweise aus der EP 1 521 309 A1 als bekannt hervor. Gemäß diesem Dokument ist es wesentlich, dass in Trennlinien zwischen benachbarten Einzelelementen, die in Serie geschaltet werden sollen, besondere Leiterkörper eingebracht sind, welche zum Kontaktieren der oberen leitenden Schicht einer Solarzelle mit der unteren leitenden Schicht einer benachbarten Solarzelle herangezogen werden. Daher muss von vorneherein festgelegt werden, an welchen Linien des Bauteils eine Trennung bzw. Serienschaltung erfolgen soll und außerdem werden zusätzlich zu den Halbleiterkörnern leitfähige Elemente, wie Drähte oder Körner, eingebettet werden, was die Produktion komplizierter macht.

Demgegenüber ist es eine Aufgabe der Erfindung, ein Verfahren bzw. ein entsprechendes Photovoltaikbauteil zu schaffen, welches die Herstellung vereinfacht und flexibel hinsichtlich der Geometrie der Verbindungsstellen im Sinne einer Serienschaltung ist.

Diese Aufgabe wird mit einem Verfahren der eingangs genannten Art gelöst, bei welchem erfindungsgemäß zunächst ein Photovoltaikbaustein vollflächig ohne Trenngräben hergestellt wird, wobei auf/in der Isolierschicht Halbleiterkörner in Abstand voneinander angeordnet werden, auf die obere Fläche der Bausteins eine die freien Oberflächen der Halbleiterkörner kontaktierende leitende Frontkontaktschicht aufgebracht wird und unterhalb der Isolierschicht die leitende Unterschicht so aufgebracht wird, dass die Halbleiterkörner in leitender Verbindung mit der Unterschicht stehen, und daraufhin an einer Seite jedes gewünschten Trenngrabens längs eines Streifens die Frontkontaktschicht samt einem oberen Abschnitt der Halbleiterkörner abgetragen wird, ein eine Teilbreite des Trenngrabens überbrückender, elektrisch leitender Verbindungsstreifen aufgebracht wird, welcher auf einer Seite des Trenngrabens die nicht abgetragenen Frontkontaktschichten der Halbleiterkörner und auf der anderen Seite die Oberflächen der unteren, nach dem Abtragen verbliebenen Kornreste elektrisch leitend bedeckt, wobei im Bereich des Trenngrabens in der leitenden Unterschicht eine bis zu der Isolierschicht bzw. der Unterseite der Halbleiterkörner reichende Trennfuge angeordnet wird.

Dank der Erfindung kann man einen großflächigen Photovoltaikbaustein ohne Festlegung von späteren Trennstellen herstellen und sodann eine gewünschte Unterteilung in einzelne Solarzellen vornehmen, die in Serie geschaltet werden.

Die Herstellung wird erleichtert, wenn die Isolierschicht auf einer unteren Trägerfolie aufgebaut wird und diese Trägerfolie vor dem Aufbringen der leitenden Unterschicht entfernt wird.

Im Sinne einer sicheren elektrischen Kontaktierung ist es dabei zweckmäßig, wenn nach dem Entfernen der Trägerfolie und vor dem Aufbringen der leitenden Unterschicht ein Reinigen der Rückseite durch Abtragen einer oberflächlichen Schicht erfolgt.

Gleichfalls zur Erleichterung der Herstellung aber auch zum Schutz des fertiggestellten Bauteils ist es vorteilhaft, falls auf die Frontseite des Bauteils nach Aufbringen des elektrisch leitenden Verbindungsstreifens eine transparente Frontseitenstabilisierung aufgebracht wird.

Dabei ist es zweckmäßig, falls die transparente Frontseitenstabilisierung vor dem Entfernen der unteren Trägerfolie aufgebracht wird.

In Hinblick auf die gewünschten geringen Toleranzen und die geringen Schichtdicken ist es besonders vorteilhaft, wenn das Abtragen der Frontkontaktschicht samt einem oberen Abschnitt der Halbleiterkörner längs eines Streifens durch Laserfräsen erfolgt.

In analoger Weise wird die Aufgabe mit einem Photovoltaikbauteil der oben definierten Art gelöst, bei welchem erfindungsgemäß an einer Seite jedes Trenngrabens längs eines Streifens die Frontkontaktschicht samt einem oberen Abschnitt der Halbleiterkörner abgetragen ist, ein eine Teilbreite des Trenngrabens überbrückender, elektrisch leitender Verbindungsstreifen aufgebracht ist, welcher auf einer Seite des Trenngrabens die nicht abgetragenen Frontkontaktschichten der Halbleiterkörner und auf der anderen Seite die Oberflächen der unteren, nach dem Abtragen verbliebenen Kornreste elektrisch leitend bedeckt, und im Bereich des Trenngrabens in der leitenden Unterschicht eine bis zu der Isolierschicht bzw. der Unterseite der Halbleiterkörner reichende Trennfuge angeordnet ist, sodass ein Stromfluss von der Frontkontaktschicht einer Solarzelle zu der leitenden Unterschicht einer benachbarten Solarzelle über die Kornreste in dem Trenngraben möglich ist.

Zur Verbesserung der Stabilität und zum Schutz der photovoltaisch wirksamen Elemente ist es ratsam, wenn an der Frontseite des Bauteils eine auch den elektrischen leitenden Verbindungsstreifen bedeckende transparente Frontseitenstabilisierung aufgebracht ist.

Eine weitere Verbesserung des Schutzes gegen äußere Einwirkungen ergibt sich, falls die Unterseite des Photovoltaikbauteils durch eine Bodenschicht abgedeckt ist.

Dabei ist es empfehlenswert, wenn die Bodenschicht eine Kunststofffolie ist.

Die Erfindung samt weiterer Vorteile ist im Folgenden an Hand beispielsweiser Ausführungsformen näher erläutert, die in der Zeichnung veranschaulicht sind. In dieser zeigen
**Fig. 1** bis **6** an Hand von Schnitten im Bereich eines Trenngrabens eines Photovoltaikbausteins vier Schritte des erfindungsgemäßen Verfahrens,
**Fig. 7** einen Schnitt durch ein Halbleiterkorn mit oberen und unteren leitenden Schichten,
**Fig. 8** einen Schnitt durch ein Halbleiterkorn, bei dem im Bereich des Trenngrabens ein oberer Abschnitt abgetragen wurde, und
**Fig. 9** in schematischer Draufsicht ein aus neun in Serie geschalteten Einzelelementen bestehendes Photovoltaikbauteil.

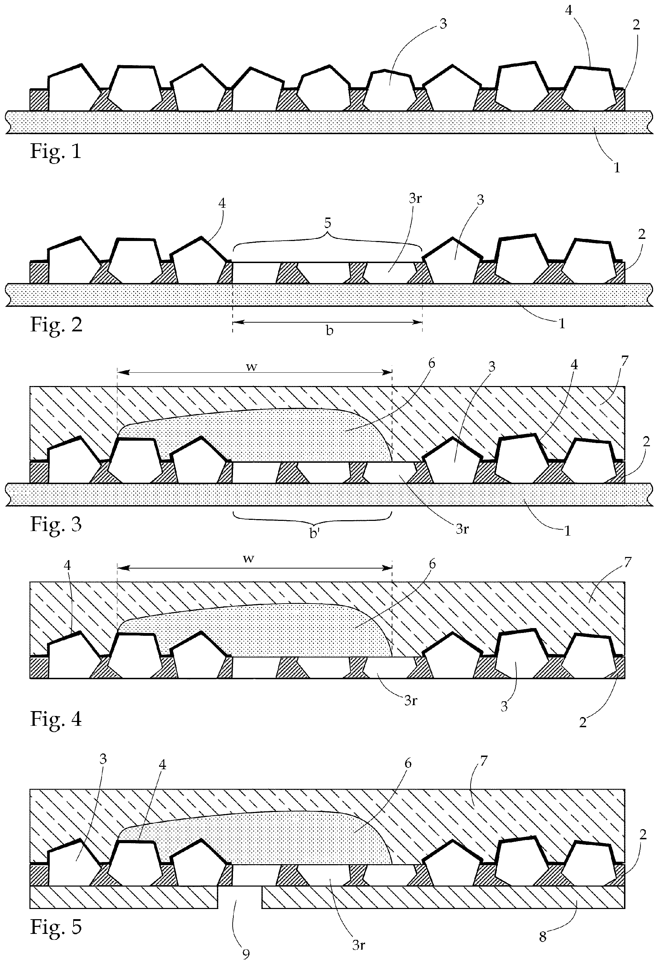

Gemäß **Fig. 1** wird nun in einem ersten Schritt auf einen Träger, insbesondere eine Trägerfolie **1** eine Isolierschicht **2** aufgebracht. Die Isolierschicht 2 besteht bevorzugt aus einem Polymermaterial, wie beispielsweise aus Epoxidharzen, Polyacrylaten, Polyurethanen, Polyetherestern und Wachsen, wobei ihre Dicke in einem weiten Bereich, letztlich auch abhängig von den Abmessungen der verwendeten Halbleiterkörner, von z.B. 1 µm bis 3 mm liegen kann.

In diese Schicht werden nun in einem nächsten Schritt Halbleiterkörner **3** so eingebettet, dass sie an einer Frontseite, in der Zeichnung die Oberseite, vorragen. Die Halbleiterkörner 3, welche typische Größenabmessungen zwischen 1 µm (Mikrometer) und 3 mm besitzen und beispielsweise sphärisch oder zylinderförmig aber auch unregelmäßig ausgebildet sein können, bestehen aus einem halbleitenden Material, dem Basismaterial, und sind mit einem weiteren halbleitenden Material, dem Emittermaterial, beschichtet. Das Emitter- und das Basismaterial können aus unterschiedlich dotierten, z.B. p-dotierten und n-dotierten Halbleitern bestehen. Es ist auch möglich, unterschiedliche Materialien zu verwenden und einen Heteroübergang zu bilden.

Das Einbringen der Halbleiterkörner 3 kann bevorzugt durch Einstreuen oder durch Verwendung elektrostatischer Felder zum Einbetten in eine weiche Isolierschicht 2 erfolgen. Eine andere Möglichkeit besteht darin, eine Transferwalze zum Übertragen der Körner in die Isolierschicht zu verwenden. Im Allgemeinen wird eine Isolierschicht verwendet, die nach dem Einbringen der Halbleiterkörner ausgehärtet werden kann.

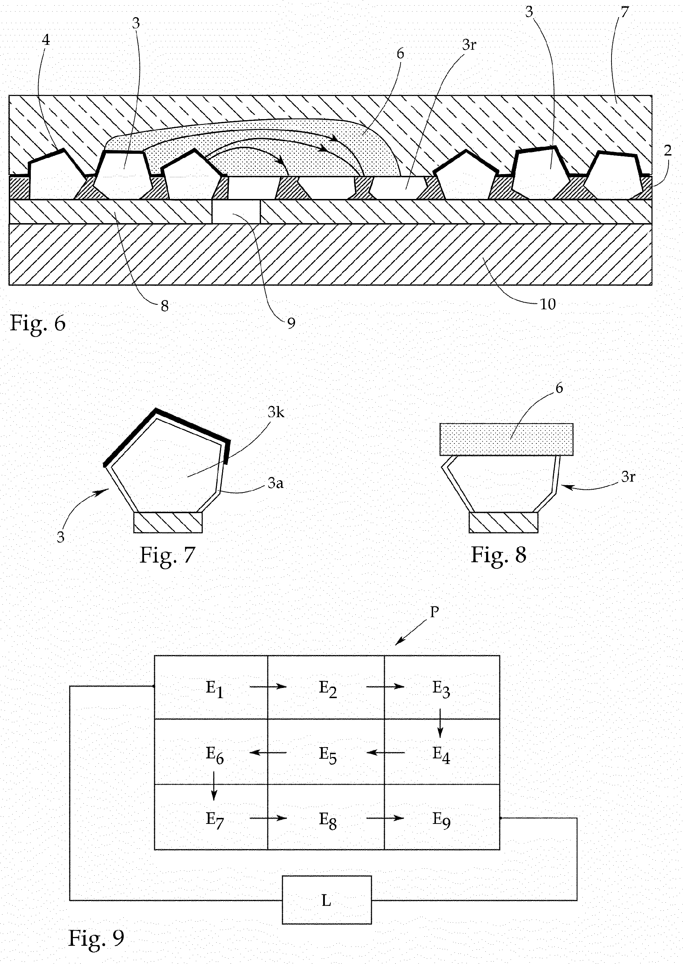

In der vergrößerten Darstellung nach **Fig. 7** kann man bei einer beispielsweisen Ausbildung den Kern **3k** eines Halbleiterkorns 3, welcher aus einem Basismaterial besteht und eine Außenschicht **3a** des Halbleiterkorns 3 erkennen, welche aus einem Emittermaterial besteht. Beispiele für typische Basismaterialien sind Silicium (Si), Galliumarsenid (GaAs), Kupfer-Indium-Gallium-Diselenid (CIGS), Cadmiumtellurid (CdTe) und Kupfer-Zink-Zinnsulfid (CZTS), für Emittermaterialien amorphes Silizium (a-Si), Cadmiumsulfid (CdS), Zinkoxide (ZnO), Zinnoxide (SnO), doch kommen sind dem Fachmann viele andere Materialien bekannt, die hier eingesetzt werden können.

In einem nächsten Schritt wird auf die aus der Isolierschicht 2 vorstehenden Abschnitte der Halbleiterkörner 3 eine leitende Frontkontaktschicht **4** aufgebracht, welche auch die zwischen den Halbleiterkörnern 3 liegenden Bereiche der Isolierschicht 2 bedeckt. Die Frontkontaktschicht 4 besteht bevorzugt jedoch nicht notwendigerweise aus transparenten leitfähigen Oxiden, wie beispielsweise aus Indiumzinnoxid (ITO), Aluminiumzinkoxid (AZO), Indiumzinkoxid (IZO) und/oder aus leitfähigen Nanostrukturen, wie Silber-Nanodrähten.

In einem nächsten Schritt werden - siehe **Fig. 2** -Trenngräben **5** hergestellt, und zwar dadurch, dass längs eines Streifens über eine Breite **b** und eine bestimmte Länge die Frontkontaktschicht 4 samt einem oberen Abschnitt der in dem Streifen gelegenen Halbleiterkörner 3 abgetragen wird. Dieses Abtragen kann mechanisch erfolgen, bevorzugt jedoch durch Laserfräsen, wobei eine Pulsdauer des verwendeten Lasers von weniger als 10 ps zweckmäßig ist. Durch dieses Abtragen ist die elektrische Verbindung zwischen den Halbleiterkörnern 3 und der Frontkontaktschicht 4 zu beiden Seiten des Trenngrabens unterbrochen und es verbleiben im Bereich des Trenngrabens Kornreste **3r,** wobei im gezeigten Schnitt drei Kornreste erkenntlich sind.

Nun wird in einem nächsten Schritt - siehe **Fig. 3** - ein eine Teilbreite **b'** des Trenngrabens 5 überbrückender, elektrisch leitender Verbindungsstreifen **6,** dessen Breite **w** größer als die Teilbreite ist, so aufgebracht, dass er einerseits auf einer Seite des Trenngrabens 5 mit den nicht abgetragenen Frontkontaktschichten 4 der Halbleiterkörner 3 und andererseits im Bereich des Trenngrabens mit den nach dem Abtragen verbliebenen Abschnitten von Halbleiterkörnern 3 elektrisch in Verbindung steht.

In einem nächsten Schritt wird zweckmäßigerweise eine Frontseitenstabilisierung **7,** z.B. eine transparente Folie, aufgebracht und daraufhin wird die untere Trägerfolie 1 entfernt, nämlich abgezogen und es kann ein flächiges Abtragen einer dünnen Schicht an nun freigelegten der Unterseite vorgenommen werden, um eine sichere Kontaktierung mit einer darnach aufzubringenden leitenden Unterschicht zu gewährleisten. Bei diesem Reinigen wird eine oberflächliche Schicht z.B. durch Polieren, Ätzen oder Laserablation abgetragen. Das Bauteil befindet sich nun in einem Zustand wie in **Fig. 4** gezeigt.

Nun wird - siehe **Fig. 5** - eine elektrisch leitende Unterschicht **8** aufgebracht, die beispielsweise aus Silber bestehen kann. Wichtig ist nun, dass diese elektrisch leitende Unterschicht 8 im Bereich des Trenngrabens 5 durch eine vergleichsweise schmale Trennfuge **9** unterbrochen ist, nämlich an jener Seite der Trennfuge, welche von den teilweise abgetragenen Halbleiterkörnern im Trenngraben 5 entfernt gelegen ist. Diese Trennfuge 9 kann durch selektives Aufbringen der elektrisch leitenden Unterschicht 8 entstehen oder sie kann alternativ durch späteres Abtragen der zunächst vollflächig aufgebrachten elektrisch leitenden Unterschicht 8 hergestellt werden. Die Trennfuge 9 sollte nicht sehr breit sein, wobei die gewünschte, möglichst geringe Breite in der Praxis durch die Fertigungstoleranzen bestimmt wird, die je nach Art der Herstellung in der Größenordnung von 10 -100 µm (Mikrometer) liegen. **Fig. 8** zeigt in einem vergrößerten Detail die obere und untere Kontaktierung eines Kornrestes 3r einerseits durch den elektrisch leitender Verbindungsstreifen **6** und andererseits durch die elektrisch leitende Unterschicht 8.

Im Anschluss daran kann, wie **Fig. 6** zeigt, eine Bodenschicht **10** aufgebracht werden, die zur Stabilisierung oder zur Abdichtung dient und beispielsweise eine Kunststofffolie ist.

In Fig. 6 ist auch zur besseren Veranschaulichung der durch die Erfindung erreichten Serienschaltung zweier benachbarter, durch einen Trenngraben "getrennter" Solarzellen symbolisch durch strichlierte Pfeile ein Stromverlauf von "links" nach "rechts" und von "oben" nach "unten" veranschaulicht.

**Fig. 9** zeigt zur weiteren Veranschaulichung die Serienschaltung von neun Einzelelementen **E₁....E₉** eines Photovoltaikbauteils **P,** wobei der Stromverlauf über die einzelnen Trenngräben zu einer angeschlossenen Last durch Pfeile angedeutet ist. Man erkennt, dass hier die Trenngräben parallel und orthogonal zueinander verlaufen, um die gewünschte Trennung des Bauteils P in neun Einzelelemente E₁....E₉ sowie deren Serienschaltung zu ermöglichen.

Daran erkennt man, dass die Erfindung bezüglich der Ausgestaltung eines Photovoltaikelementes sehr flexibel ist, da Serienschaltungen in beliebigen Richtungen einer Ebene möglich sind. Dabei sollte dem Fachmann auch klar sein, dass die Linien, längs welcher die Trenngräben verlaufen, nicht zwingenderweise Gerade sein müssen, sondern auch gekrümmt, beispielsweise wie Kreisbögen, sein können.

Sämtliche beschriebenen Schichten können durch geeignete Verfahren aufgebracht bzw. abgeschieden werden, insbesondere durch Druckverfahren, wie Tintenstrahldruck, Siebdruck, Gravurdruck, Flexodruck, Aerosol-Jet-Druck oder durch physikalische/chemische Abscheidungsverfahren, so z.B. durch Abscheidung aus der Gasphase.

Begriffe wie oben, unten, vorne, hinten, Frontseite und sinnverwandte Begriffe, die Lagen oder Richtungen angeben, werden in Zusammenhang mit den Zeichnungen verwendet, um deren Beschreibung zu erleichtern, beziehen sich jedoch nicht auf die tatsächliche Lage bei Verwendung.

**Liste der Bezugszeichen**

| | | | |
|---|---|---|---|
| 1 | Trägerfolie | E1....E9 | Einzelelemente |
| 2 | Isolierschicht | L | Last |
| 3 | Halbleiterkorn | P | Photovoltaikbauteil |
| 3a | Außenschicht | | |
| 3k | Kern | | |
| 3r | Kornrest | | |
| 4 | Frontkontaktschicht | | |
| 5 | Trenngraben | | |
| 6 | Verbindungsstreifen | | |
| 7 | Frontseitenstabilisierung | | |
| 8 | Unterschicht | | |
| 9 | Trennfuge | | |
| 10 | Bodenschicht | | |

## Patentansprüche

1. Verfahren zur Herstellung eines Photovoltaikbauteils (P), welches aus einzelnen, in Serie geschalteten Solarzellen (Ei...E9) besteht,
wobei in jeder Solarzelle Halbleiterkörner (3) in einer Isolierschicht (2) angeordnet sind, aus welcher die Halbleiterkörner an einer Frontseite vorragen, an einer gegenüberliegenden Rückseite auf einer leitenden Unterschicht (8) sitzen und an der Frontseite mit einer leitenden Frontkontaktschicht (4) in elektrischer Verbindung stehen,
wobei zwischen benachbarten Solarzellen (E₁, E₂) ein Trenngraben (5) vorgesehen ist, in dessen Bereich die Solarzellen elektrisch dadurch miteinander in Serie geschaltet sind, dass je die Frontkontaktschicht einer Solarzelle (E₁) mit der leitenden Unterschicht einer benachbarten Solarzelle (E₂) verbunden ist,
**dadurch gekennzeichnet, dass**
zunächst ein Photovoltaikbaustein (P) vollflächig ohne Trenngräben hergestellt wird, wobei auf/in der Isolierschicht Halbleiterkörner (3) in Abstand voneinander angeordnet werden, auf die obere Fläche der Bausteins eine die freien Oberflächen der Halbleiterkörner kontaktierende leitende Frontkontaktschicht (4) aufgebracht wird und unterhalb der Isolierschicht (2) die leitende Unterschicht (8) so aufgebracht wird, dass die Halbleiterkörner in leitender Verbindung mit der Unterschicht stehen, und
**dass** daraufhin an einer Seite jedes gewünschten Trenngrabens (5) längs eines Streifens die Frontkontaktschicht samt einem oberen Abschnitt der Halbleiterkörner abgetragen wird,
ein eine Teilbreite (b') des Trenngrabens (5) überbrückender, elektrisch leitender Verbindungsstreifen (6) aufgebracht wird, welcher auf einer Seite des Trenngrabens die nicht abgetragenen Frontkontaktschichten (4) der Halbleiterkörner (3) und auf der anderen Seite die Oberflächen der unteren, nach dem Abtragen verbliebenen Kornreste (3r) elektrisch leitend bedeckt, wobei im Bereich des Trenngrabens in der leitenden Unterschicht (8) eine bis zu der Isolierschicht (2) bzw. der Unterseite der Halbleiterkörner (3) reichende Trennfuge (9) angeordnet wird.

2. Verfahren nach Anspruch 1, **dadurch gekennzeichnet, dass** die Isolierschicht (2) auf einer unteren Trägerfolie (1) aufgebaut wird und diese Trägerfolie vor dem Aufbringen der leitenden Unterschicht (8) entfernt wird.

3. Verfahren nach Anspruch 2, **dadurch gekennzeichnet, dass** nach dem Entfernen der Trägerfolie (1) und vor dem Aufbringen der leitenden Unterschicht (8) ein Reinigen der Rückseite durch Abtragen einer oberflächlichen Schicht erfolgt.

4. Verfahren nach einem der Ansprüche 1 bis 3, **dadurch gekennzeichnet, dass** auf die Frontseite des Bauteils (P) nach Aufbringen des elektrisch leitenden Verbindungsstreifens (6) eine transparente Frontseitenstabilisierung (7) aufgebracht wird.

5. Verfahren nach Anspruch 4, **dadurch gekennzeichnet, dass** die transparente Frontseitenstabilisierung (7) vor dem Entfernen der unteren Trägerfolie (1) aufgebracht wird.

6. Verfahren nach einem der Ansprüche 1 bis 5, **dadurch gekennzeichnet, dass** das Abtragen der Frontkontaktschicht (4) samt einem oberen Abschnitt der Halbleiterkörner (3) längs eines Streifens durch Laserfräsen erfolgt.

7. Photovoltaikbauteil (P), welches aus einzelnen, in Serie geschalteten Solarzellen (E₁...E₉) besteht,
wobei in jeder Solarzelle Halbleiterkörner (3) in einer Isolierschicht (2) angeordnet sind, aus welcher die Halbleiterkörner an einer Frontseite vorragen, an einer gegenüberliegenden Rückseite auf einer leitenden Unterschicht (8) sitzen und an der Frontseite mit einer leitenden Frontkontaktschicht (4) in elektrischer Verbindung stehen,
wobei zwischen benachbarten Solarzellen (E₁, E₂) ein Trenngraben vorgesehen ist, in dessen Bereich die Solarzellen elektrisch dadurch miteinander in Serie geschaltet sind, dass je die Frontkontaktschicht einer Solarzelle (E₁) mit der leitenden Unterschicht einer benachbarten Solarzelle (E₂) verbunden ist,
**dadurch gekennzeichnet, dass**
an einer Seite jedes Trenngrabens (5) längs eines Streifens die Frontkontaktschicht (4) samt einem oberen Abschnitt der Halbleiterkörner (3) abgetragen ist,
ein eine Teilbreite (b') des Trenngrabens (5) überbrückender, elektrisch leitender Verbindungsstreifen (6) aufgebracht ist, welcher auf einer Seite des Trenngrabens die nicht abgetragenen Frontkontaktschichten der Halbleiterkörner und auf der anderen Seite die Oberflächen der unteren, nach dem Abtragen verbliebenen Kornreste (3r) elektrisch leitend bedeckt, und im Bereich des Trenngrabens in der leitenden Unterschicht (8) eine bis zu der Isolierschicht (2) bzw. der Unterseite der Halbleiterkörner (3) reichende Trennfuge (9) angeordnet ist, sodass ein Stromfluss von der Frontkontaktschicht einer Solarzelle (E₁) zu der leitenden Unterschicht einer benachbarten Solarzelle (E₂) über die Kornreste (3r) in dem Trenngraben möglich ist.

8. Photovoltaikbauteil (P) nach Anspruch 7, **dadurch gekennzeichnet, dass** an der Frontseite des Bauteils (P) eine auch den elektrischen leitenden Verbindungsstreifen (6) bedeckende transparente Frontseitenstabilisierung (7) aufgebracht ist.

9. Photovoltaikbauteil (P) nach Anspruch 7 oder 8, **dadurch gekennzeichnet, dass** seine Unterseite durch eine Bodenschicht (10) abgedeckt ist.

10. Photovoltaikbauteil (P) nach Anspruch 9, **dadurch gekennzeichnet, dass** die Bodenschicht (10) eine Kunststofffolie ist.

## Claims

1. A method for the production of a photovoltaic component (P) which is made of individual, series-connected solar cells (E₁...E₉),
wherein in each solar cell semiconductor grains (3) are arranged in an insulating layer (2) from which the semiconductor grains project on a front side, sit on a conducting lower layer (8) on an opposite rear side and are electrically connected to a conducting front contact layer (4) on the front side,
wherein a separating trough (5) is provided between adjacent solar cells (E₁, E₂), in the region whereof the solar cells are electrically series-connected to one another in that each front contact layer of a solar cell (E₁) is connected to the conducting lower layer of an adjacent solar cell (E₂),
**characterized in that**
a photovoltaic component (P) is initially completely produced without separating troughs, wherein semiconductor grains (3) are arranged on/in the insulating layer spaced apart from one another, a conducting front contact layer (4) making contact with the free surfaces of the semiconductor grains is applied to the upper surface of the component and below the insulating layer (2) the conducting lower layer (8) is applied in such a manner that the semiconductor grains are conductively connected to the lower layer and
that then on one side of each required separating trough (5) the front contact layer plus an upper portion of the semiconductor grains is removed along a strip,
an electrically conductive connection strip (6) bridging a partial width (b') of the separating trough (5) is applied which, on one side of the separating trough, covers the front contact layers (4) of the semiconductor grains (3) which have not been removed and, on the other side, the surfaces of the lower grain residues (3r) remaining following the removal in an electrically conductive manner, wherein in the region of the separating trough in the conducting lower layer (8) a joint (9) extending up to the insulating layer (2) or the lower side of the semiconductor grains (3) is arranged.

2. The method according to claim 1, **characterized in that** the insulating layer (2) is constructed on a lower carrier film (1) and this carrier film is removed before the conductive lower layer (8) is applied.

3. The method according to claim 2, **characterized in that** following removal of the carrier film (1) and prior to application of the conductive lower layer (8), cleaning of the rear side through removal of a surface layer takes place.

4. The method according to one of claims 1 to 3, **characterized in that** on the front side of the component (P) following application of the electrically conductive connection strip (6) a transparent front side stabilization (7) is applied.

5. The method according to claim 4, **characterized in that** the transparent front side stabilization (7) is applied prior to removal of the lower carrier film (1).

6. The method according to one of claims 1 to 5, **characterized in that** removal of the front contact layer (4) plus an upper portion of the semiconductor grains (3) takes place along a strip by laser milling.

7. A photovoltaic component (P) which is made of individual, series-connected solar cells (E₁...E₉),
wherein semiconductor grains (3) are arranged in an insulating layer (3) in each solar cell, from which insulating layer the semiconductor grains project on a front side, sit on a conducting lower layer (8) on an opposite rear side and are electrically connected to a conducting front contact layer (4) on the front side,
wherein a separating trough (5) is provided between adjacent solar cells (E₁, E₂), in the region whereof the solar cells are electrically series-connected to one another in that each front contact layer of a solar cell (E₁) is connected to the conducting lower layer of an adjacent solar cell (E₂),
**characterized in that**
on one side of each separating trough (5) the front contact layer (4) plus an upper portion of the semiconductor grains (3) is removed along a strip,
an electrically conductive connection strip (6) bridging a partial width (b') of the separating trough (5) is applied which, on one side of the separating trough, covers the front contact layers of the semiconductor grains which have not been removed and, on the other side, the surfaces of the lower grain residues (3r) remaining following the removal in an electrically conductive manner, wherein in the region of the separating trough in the conducting lower layer (8) a joint (9) extending up to the insulating layer (2) or the lower side of the semiconductor grains (3) is arranged, so that a current flow from the front contact layer of a solar cell (E₁) to the conducting lower layer of an adjacent solar cell (E₂) is possible via the grain residues (3r) in the separating trough.

8. The photovoltaic component (P) according to claim 7, **characterized in that** on the front side of the component (P) a transparent front side stabilization (7) also covering the electrically conductive connection strip (6) is applied.

9. The photovoltaic component (P) according to claim 7 or 8, **characterized in that** its underside is covered by a base layer (10).

10. The photovoltaic component (P) according to claim 9, **characterized in that** the base layer (10) is a plastics film.

## Revendications

1. Procédé, destiné à fabriquer un composant photovoltaïque (P), lequel est constitué de cellules solaires (E₁...E₉) individuelles, connectées en série,
dans chaque cellule solaire, des grains semi-conducteurs (3) étant placés dans une couche isolante (2), à partir de laquelle les grains semi-conducteurs saillissent sur une face frontale, en reposant sur une face arrière opposée sur une couche inférieure (8) conductrice et en étant en liaison électrique sur la face frontale avec une couche frontale de contact (4) conductrice,
entre des cellules solaires (E₁, E₂) voisines étant prévue une tranchée séparatrice (5) dans la zone de laquelle les cellules solaires sont électriquement connectées en série les unes avec les autres en ce que chaque fois la couche frontale de contact d'une cellule solaire (E₁) est reliée avec une couche inférieure conductrice d'une cellule solaire (E₂) voisine,
**caractérisé**
**en ce qu'**on fabrique d'abord un élément photovoltaïque (P) à pleine surface, sans tranchées séparatrices, on place sur/ dans la couche isolante des grains semi-conducteurs (3) avec un écart mutuel, sur la surface supérieure de l'élément, on applique une couche frontale de contact (4) entrant en contact avec les grains semi-conducteurs libres, et en-dessous de la couche isolante (2), on applique la couche inférieure (8) conductrice, de telle sorte que les grains semi-conducteurs se trouvent en liaison conductrice avec la couche inférieure, et
**en ce qu'**on enlève ensuite sur un côté de chaque tranchée séparatrice (5) souhaitée, le long d'une bande, la couche frontale de contact, ainsi qu'une section supérieure des grains semi-conducteurs,
on applique une bande de liaison (6) conductrice d'électricité enjambant une largeur partielle (b') de la tranchée séparatrice (5), laquelle recouvre de manière conductrice d'électricité sur un côté de la tranchée séparatrice les couches frontales de contact (4) non enlevées des grains semi-conducteurs (3) et sur l'autre côté les surfaces des restes de grains (3r) inférieurs, restants après l'enlèvement, dans la zone de la tranchée séparatrice, dans la couche inférieure (8) conductrice, on place une jointure (9) arrivant jusqu'à la couche isolante (2) ou à la face inférieure des grains semi-conducteurs (3).

2. Procédé selon la revendication 1, **caractérisé en ce qu'**on construit la couche isolante (2) sur un film de support (1) inférieur et on retire ledit film de support avant l'application de la couche inférieure (8) conductrice.

3. Procédé selon la revendication 2, **caractérisé en ce qu'**après le retrait du film de support (1) et avant l'application de la couche inférieure (8) conductrice, un nettoyage de la face arrière a lieu par enlèvement d'une couche superficielle.

4. Procédé selon l'une quelconque des revendications 1 à 3, **caractérisé en ce que** sur la face frontale du composant (P), après l'application de la bande de liaison (6) conductrice d'électricité, on applique une stabilisation de face frontale (7) transparente.

5. Procédé selon la revendication 4, **caractérisé en ce qu'**on applique la stabilisation de face frontale (7) transparente avant le retrait du film de support (1) inférieur.

6. Procédé selon l'une quelconque des revendications 1 à 5, caractérisé en ce l'enlèvement de la couche frontale de contact (4) ainsi que d'une section supérieure des grains semi-conducteurs (3) le long d'une bande s'effectue par fraisage au laser.

7. Composant photovoltaïque (P), lequel est constitué de cellules solaires (E₁...E₉) individuelles, connectées en série, dans chaque cellule solaire, des grains semi-conducteurs (3) étant placés dans une couche isolante (2), à partir de laquelle les grains semi-conducteurs saillissent sur une face frontale, en reposant sur une face arrière opposée sur une couche inférieure (8) conductrice et en étant en liaison électrique sur la face frontale avec une couche frontale de contact (4) conductrice,
entre des cellules solaires (E₁, E₂) voisines étant prévue une tranchée séparatrice (5) dans la zone de laquelle les cellules solaires sont électriquement connectées en série les unes avec les autres en ce que chaque fois la couche frontale de contact d'une cellule solaire (E₁) est reliée avec une couche inférieure conductrice d'une cellule solaire (E₂) voisine,
**caractérisé en ce que**
sur un côté de chaque tranchée séparatrice (5), le long d'une bande, la couche frontale de contact (4) est enlevée, ainsi qu'une section supérieure des grains semi-conducteurs (3),
une bande de liaison (6) conductrice d'électricité enjambant une largeur partielle (b') de la tranchée séparatrice (5) est appliquée, laquelle recouvre de manière conductrice d'électricité sur un côté de la tranchée séparatrice les couches frontales de contact (4) non enlevées des grains semi-conducteurs (3) et sur l'autre côté, les surfaces des restes de grains (3r) inférieurs, restants après l'enlèvement et dans la zone de la tranchée séparatrice, dans la couche inférieure (8) conductrice est placée une jointure (9) arrivant jusqu'à la couche isolante (2) ou à la face inférieure des grains semi-conducteurs (3), de telle sorte qu'un flux de courant soit possible dans la tranchée séparatrice, de la couche frontale de contact d'une cellule solaire (E1) vers la couche inférieure conductrice d'une cellule solaire (E2) voisine, par l'intermédiaire des restes de grains (3r).

8. Composant photovoltaïque (P) selon la revendication 7, **caractérisé en ce que** sur la face frontale du composant (P) est appliquée une stabilisation de face frontale (7) transparente recouvrant également la bande de liaison (6) conductrice d'électricité.

9. Composant photovoltaïque (P) selon la revendication 7 ou 8, **caractérisé en ce que** sa face inférieure est recouverte d'une couche de fond inférieur (10).

10. Composant photovoltaïque (P) selon la revendication 9, **caractérisé en ce que** la couche de fond inférieur (10) est un film en matière plastique.
